# DEMANDE DE BREVET EUROPEEN

(11) **EP 4 567 861 A1**
(43) Date de publication de la demande: **11.06.2025**
(21) Numéro de dépôt: 24217215.3
(22) Date de dépôt: 03.12.2024
(51) Int. Cl.: H01L 21/20

(54) **PROCÉDÉ DE FABRICATION D'UNE COUCHE CRISTALLINE**

(30) Priorité: 06.12.2023 FR 2313703
(71) Demandeur: Commissariat à l'Energie Atomique et aux Energies Alternatives, 75015 Paris (FR)
(72) Inventeur: HYOT, Bérangère, 38054 GRENOBLE (FR); BERNARD, Mathieu, 38054 GRENOBLE (FR); CADOT, Stéphane, 38054 GRENOBLE (FR); DUSSAIGNE, Amélie, 38054 GRENOBLE (FR); GASSILLOUD, Rémy, 38054 GRENOBLE (FR); RAYNAUD, Christine, 38054 GRENOBLE (FR); PATOUILLARD, Julien, 38100 GRENOBLE (FR)
(74) Mandataire: INNOV-GROUP

(57) **Abrégé**

Ce procédé comporte les étapes :
a) utiliser un substrat (1) comprenant un film superficiel (2) réalisé dans un dichalcogénure d'un métal de transition, noté MX₂, où « M » désigne un métal de transition et « X » désigne un chalcogène ; le film superficiel (2) comprenant un ensemble de monocouches liées entre elles par des liaisons de van der Waals ;
b) former un film (3) de nitrure d'aluminium AlN polycristallin, possédant des joints de grain, sur le film superficiel (2) ;
c) diffuser des éléments (E) métalliques dans le film superficiel (2), à travers les joints de grain du film (3) de nitrure d'aluminium AlN polycristallin, les éléments (E) métalliques étant choisis pour réagir chimiquement avec MX₂ par une réaction d'oxydoréduction de manière à transformer les liaisons de van der Waals en liaisons covalentes ;
d) former une couche cristalline sur le film (3) de nitrure d'aluminium AlN polycristallin après l'étape c).

## Description

### Domaine technique

L'invention se rapporte au domaine technique de la fabrication d'une couche cristalline, épaisse (i.e. supérieure à 200 nm), en particulier de nitrure d'aluminium AlN, de haute qualité cristalline.

L'invention trouve notamment son application dans l'obtention de dispositifs électroniques de puissance, ou encore dans l'obtention de filtres acoustiques pour des signaux RF (radio-fréquence).

### État de l'art

Un procédé de fabrication d'une couche cristalline connu de l'état de la technique, notamment du document FR3105591 A1, comporte les étapes :
A) utiliser un substrat, par exemple en silicium, revêtu d'une couche diélectrique (e.g. oxyde, 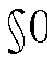 0037) ;
B) former un film superficiel sur le substrat revêtu de la couche diélectrique, le film superficiel étant réalisé dans un dichalcogénure d'un métal de transition, noté MX₂, où « M » désigne un métal de transition et « X » désigne un chalcogène ;
C) former une couche cristalline de nitrure d'aluminium AlN sur le film superficiel.

La formation directe d'une couche cristalline de nitrure d'aluminium AlN sur la couche diélectrique (surface quasi amorphe) conduit à une couche de faible qualité cristalline.

Le fait d'intercaler un tel film superficiel, agissant comme une couche de nucléation, entre la couche diélectrique et la couche cristalline de nitrure d'aluminium AlN permet d'améliorer la qualité cristalline de la couche de nitrure d'aluminium AlN formée, car le désaccord de maille cristalline entre le film superficiel et la couche de nitrure d'aluminium AlN est typiquement inférieur ou égal à 1,5%.

Toutefois, un tel procédé de l'état de la technique n'est pas entièrement satisfaisant dans la mesure où la formation d'une couche cristalline de nitrure d'aluminium AlN épaisse (supérieure à 200 nm), nécessaire à la fabrication de composants tels que des filtres acoustiques, est susceptible de conduire à une délamination de la couche cristalline.

### Exposé de l'invention

L'invention vise à remédier en tout ou partie aux inconvénients précités. A cet effet, l'invention a pour objet un procédé de fabrication d'une couche cristalline, comportant les étapes :
a) utiliser un substrat comprenant un film superficiel réalisé dans un dichalcogénure d'un métal de transition, noté MX₂, où « M » désigne un métal de transition et « X » désigne un chalcogène ; le film superficiel comprenant un ensemble de monocouches liées entre elles par des liaisons de van der Waals ;
b) former un film de nitrure d'aluminium AlN polycristallin, possédant des joints de grain, sur le film superficiel ;
c) diffuser des éléments métalliques dans le film superficiel, à travers les joints de grain du film de nitrure d'aluminium AlN polycristallin, les éléments métalliques étant choisis pour réagir chimiquement avec MX₂ par une réaction d'oxydoréduction de manière à transformer les liaisons de van der Waals en liaisons covalentes ;
d) former une couche cristalline sur le film de nitrure d'aluminium AlN polycristallin après l'étape c).

Ainsi, un tel procédé selon l'invention autorise la formation d'une couche cristalline épaisse (supérieure à 200 nm) en réduisant fortement les risques de délamination de la couche cristalline grâce aux étapes b) et c). En d'autres termes, la transformation chimique du film superficiel obtenue en réduisant le MX₂ permet d'éviter les risques de délamination de la couche cristalline formée lors de l'étape d).

Le procédé selon l'invention peut comporter une ou plusieurs des caractéristiques suivantes.

Selon une caractéristique de l'invention, l'étape c) est précédée d'une exposition des éléments métalliques sur le film de nitrure d'aluminium AlN polycristallin.

Ainsi, un avantage procuré est de réduire le temps d'opération (temps de processus) en s'affranchissant d'un dépôt d'un matériau comportant les éléments métalliques.

Selon une caractéristique de l'invention, l'étape c) est précédée d'une formation d'un matériau, comportant les éléments métalliques, sur le film de nitrure d'aluminium AlN polycristallin.

Ainsi, un avantage procuré est la facilité d'exécution par rapport à une exposition directe des éléments métalliques, pouvant nécessiter des techniques plus avancées.

Selon une caractéristique de l'invention, l'étape d) est précédée d'une suppression des résidus du matériau formé sur le film de nitrure d'aluminium AlN polycristallin, après la diffusion des éléments métalliques dans le film superficiel à l'issue de l'étape c).

Ainsi, un avantage procuré est de faciliter la formation de la couche cristalline par croissance épitaxiale sur le film de nitrure d'aluminium AlN polycristallin et d'accroître la qualité cristalline.

Selon une caractéristique de l'invention, les éléments métalliques diffusés lors de l'étape c) sont des atomes choisis comme agent réducteur du MX₂.

Ainsi, un avantage procuré est d'obtenir une réaction chimique avec MX₂ (réaction d'oxydoréduction) de manière à transformer les liaisons de van der Waals en liaisons covalentes.

Selon une caractéristique de l'invention, l'étape a) est exécutée de sorte que MX₂ est choisi pour posséder un désaccord de maille cristalline avec le nitrure d'aluminium AlN polycristallin inférieur ou égal à 1,5%.

Ainsi, un avantage procuré est d'obtenir une qualité cristalline satisfaisante pour le nitrure d'aluminium AlN polycristallin.

Selon une caractéristique de l'invention, l'étape a) est exécutée de sorte que MX₂ est choisi parmi le disulfure de molybdène MoS₂, le disulfure de tungstène WS₂, le disulfure de vanadium VS₂.

Ainsi, un avantage procuré par de tels matériaux est leur symétrie cristalline (i.e. hexagonale) compatible avec le nitrure d'aluminium AlN, ainsi qu'un désaccord de maille cristalline faible avec le nitrure d'aluminium AlN.

Selon une caractéristique de l'invention :
- l'étape a) est exécutée de sorte que MX₂ est le disulfure de molybdène MoS₂;
- les atomes choisis comme agent réducteur du disulfure de molybdène MoS₂ sont choisis parmi le gallium Ga, l'aluminium Al, le manganèse Mn.

Selon une caractéristique de l'invention, l'étape d) est exécutée de sorte que la couche cristalline est réalisée dans un matériau cristallin possédant un désaccord de maille cristalline avec le nitrure d'aluminium AlN polycristallin inférieur ou égal à 1,5%.

Ainsi, un avantage procuré est d'obtenir une qualité cristalline satisfaisante pour la couche cristalline.

Selon une caractéristique de l'invention, l'étape d) est exécutée de sorte que la couche cristalline est réalisée dans un matériau cristallin choisi parmi le carbure de silicium SiC et un alliage de type III-N.

Ainsi, un avantage procuré par ces matériaux est leur désaccord de maille faible avec le nitrure d'aluminium AlN polycristallin.

Selon une caractéristique de l'invention, l'alliage de type III-N est choisi parmi le nitrure d'aluminium AlN, le nitrure de gallium GaN, le nitrure d'aluminium-gallium AlGaN.

Ainsi, un avantage procuré par ces matériaux est leur désaccord de maille faible (voire nul pour le nitrure d'aluminium AlN) avec le nitrure d'aluminium AlN polycristallin.

Selon une caractéristique de l'invention, l'étape b) est exécutée de sorte que le film de nitrure d'aluminium AlN polycristallin présente une épaisseur inférieure ou égale à 5 nm.

Ainsi, un avantage procuré est de faciliter la diffusion des éléments métalliques en son sein afin d'atteindre le film de MX₂ sous-jacent.

Selon une caractéristique de l'invention, l'étape b) est exécutée par un dépôt physique en phase vapeur.

Selon une caractéristique de l'invention, l'étape d) est exécutée par un dépôt physique en phase vapeur ou par une épitaxie en phase vapeur aux organométalliques.

L'épitaxie en phase vapeur aux organométallique, exécutée à haute température (supérieure à 950°C), permet d'obtenir une meilleure qualité cristalline (augmentation de la taille des grains) par rapport à un dépôt physique en phase vapeur.

Selon une caractéristique de l'invention, l'étape d) est exécutée de sorte que la couche cristalline présente une épaisseur supérieure ou égale à 200 nm.

Ainsi, un avantage procuré est d'autoriser la fabrication de composants tels que des filtres acoustiques.

L'invention a également pour objet un empilement, comportant :
- un substrat comprenant un film superficiel réalisé dans un dichalcogénure d'un métal de transition, noté MX₂, où « M » désigne un métal de transition et « X » désigne un chalcogène ; le film superficiel comprenant des éléments métalliques adaptés pour réagir chimiquement avec MX₂ par une réaction d'oxydoréduction, le film superficiel comprenant un ensemble de monocouches liées entre elles par des liaisons covalentes ;
- un film de nitrure d'aluminium AlN polycristallin, possédant des joints de grain, et s'étendant sur le film superficiel.

Enfin, l'invention a pour objet un dispositif, comportant :
- un empilement selon l'invention ;
- une couche cristalline, s'étendant sur le film de nitrure d'aluminium AlN polycristallin.

### Définitions

- Par « cristallin/cristalline », on entend un solide dont les constituants sont assemblés de manière régulière. En d'autres termes, le diagramme de diffraction est essentiellement discret, conformément à la définition officiellement donnée par l'Union internationale de cristallographie (IUCR, *«International Union of Crystallography*»). Le solide peut être monocristallin ou polycristallin, mais pas amorphe.
- Par « substrat », on entend un support physique autoporté. Un substrat peut être une tranche (également dénommée « plaquette », « *wafer*» en langue anglaise) qui se présente généralement sous la forme d'un disque issu d'une découpe dans un lingot d'un matériau cristallin. Le substrat peut être revêtu d'une couche diélectrique, par exemple via un dépôt d'une couche diélectrique dédiée, ou via une oxydation du substrat.
- Par « désaccord de maille cristalline » (« *lattice mismatch* » en langue anglaise), on entend la différence quantitative entre les paramètres de maille des matériaux concernés.
- Par « alliage de type III-N », on entend un alliage entre au moins un élément situé dans la colonne III du tableau périodique des éléments (TPE) et l'élément azote N. A titre d'exemple non limitatif, l'alliage peut être binaire en présence d'un seul élément de la colonne III du TPE et de l'azote N. L'alliage peut être ternaire en présence de deux éléments de la colonne III du TPE et de l'azote N etc.
- Par « épaisseur », on entend la dimension suivant la normale à la surface du substrat sur laquelle est formé le film superficiel.

### Brève description des dessins

D'autres caractéristiques et avantages apparaîtront dans l'exposé détaillé de différents modes de réalisation de l'invention, l'exposé étant assorti d'exemples et de références aux dessins joints.

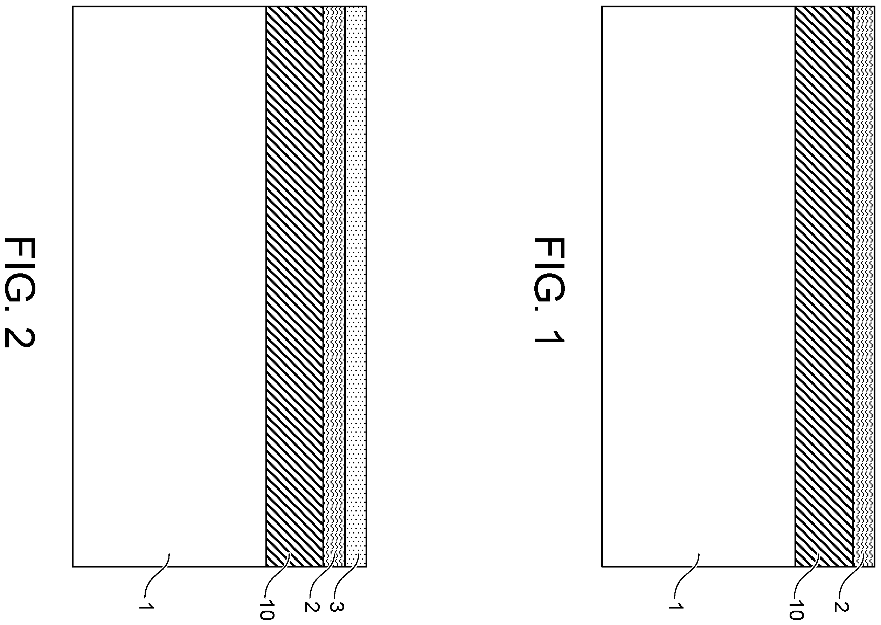

Figure 1 est une vue schématique en coupe illustrant une étape a) d'un procédé selon l'invention.
Figure 2 est une vue schématique en coupe, illustrant une étape b) d'un procédé selon l'invention.

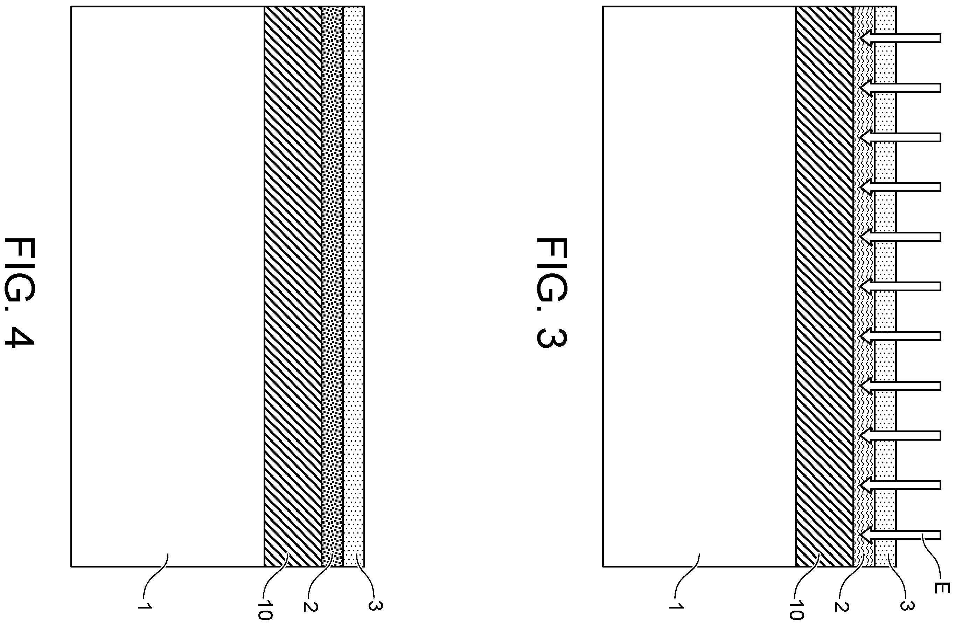

Figure 3 est une vue schématique en coupe, illustrant un premier mode de mise en oeuvre d'une étape c) d'un procédé selon l'invention, c'est-à-dire une exposition (directe) des éléments métalliques sur le film de nitrure d'aluminium AlN polycristallin, qui diffusent dans le film superficiel.
Figure 4 est une vue schématique en coupe, illustrant l'issue de l'étape c) de la figure 3 avec la transformation des liaisons de van der Waals en liaisons covalentes dans le film superficiel.

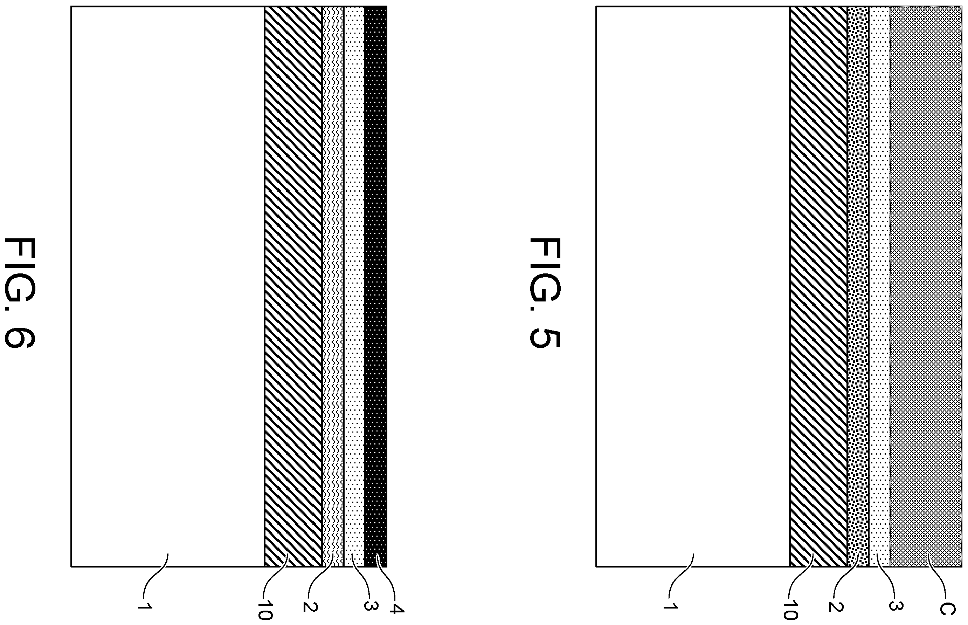

Figure 5 est une vue schématique en coupe, illustrant une étape d) d'un procédé selon l'invention exécutée à l'issue de l'étape c) illustrée à la figure 4.
Figure 6 est une vue schématique en coupe, illustrant un deuxième mode de mise en oeuvre d'une étape c) d'un procédé selon l'invention, c'est-à-dire la formation d'un matériau, comportant les éléments métalliques, sur le film de nitrure d'aluminium AlN polycristallin.

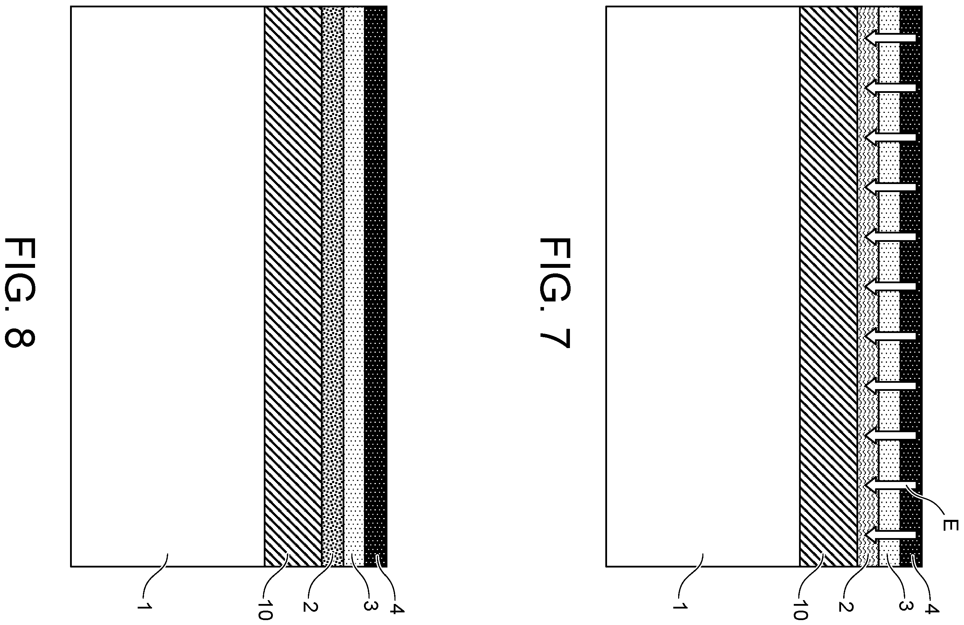

Figure 7 est une vue schématique en coupe, illustrant la diffusion des éléments métalliques depuis le matériau illustré à la figure 6 vers le film superficiel, par l'intermédiaire du film de nitrure d'aluminium AlN polycristallin.
Figure 8 est une vue schématique en coupe, illustrant l'issue de l'étape c) de la figure 7 avec la transformation des liaisons de van der Waals en liaisons covalentes dans le film superficiel.

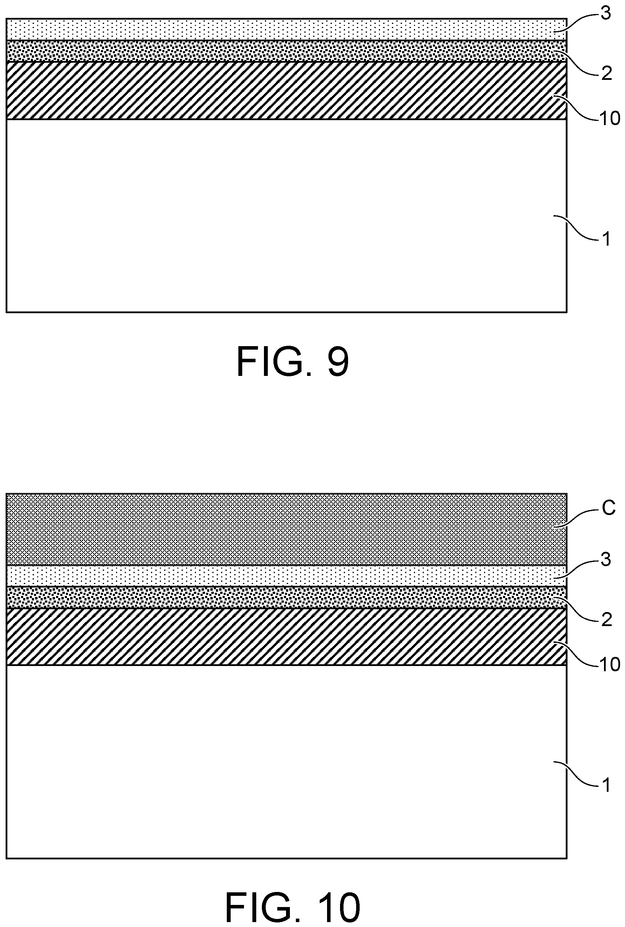

Figure 9 est une vue schématique en coupe, illustrant une suppression des résidus du matériau formé sur le film de nitrure d'aluminium AlN polycristallin, à l'issue de l'étape c) illustrée à la figure 8.
Figure 10 est une vue schématique en coupe, illustrant une étape d) d'un procédé selon l'invention exécutée après la suppression des résidus illustrée à la figure 9.

Il est à noter que les dessins décrits ci-avant sont schématiques, et ne sont pas nécessairement à l'échelle par souci de lisibilité et pour en simplifier leur compréhension. Les coupes sont effectuées selon la normale à la surface du substrat sur laquelle est formé le film superficiel.

### Exposé détaillé des modes de réalisation

Les éléments identiques ou assurant la même fonction porteront les mêmes références pour les différents modes de réalisation, par souci de simplification.

Un objet de l'invention est un procédé de fabrication d'une couche cristalline C, comportant les étapes :
a) utiliser un substrat 1 comprenant un film superficiel 2 réalisé dans un dichalcogénure d'un métal de transition, noté MX₂, où « M » désigne un métal de transition et « X » désigne un chalcogène ; le film superficiel 2 comprenant un ensemble de monocouches liées entre elles par des liaisons de van der Waals ;
b) former un film 3 de nitrure d'aluminium AlN polycristallin, possédant des joints de grain, sur le film superficiel 2 ;
c) diffuser des éléments E métalliques dans le film superficiel 2, à travers les joints de grain du film 3 de nitrure d'aluminium AlN polycristallin, les éléments E métalliques étant choisis pour réagir chimiquement avec MX₂ par une réaction d'oxydoréduction de manière à transformer les liaisons de van der Waals en liaisons covalentes ;
d) former une couche cristalline C sur le film 3 de nitrure d'aluminium AlN polycristallin après l'étape c).

### Etape a)

L'étape a) consiste à utiliser un substrat 1 comprenant un film superficiel 2 réalisé dans un dichalcogénure d'un métal de transition, noté MX₂, où « M » désigne un métal de transition et « X » désigne un chalcogène. Le métal de transition « M » peut être choisi parmi le titane Ti, le zirconium Zr, le hafnium Hf, le vanadium V, le niobium Nb, le tantale Ta, le chrome Cr, le molybdène Mo, le tungstène W, le rhénium Re. Le chalcogène « X » peut être choisi parmi le soufre S, le sélénium Se, le tellure Te.

Le substrat 1 peut être revêtu d'une couche diélectrique 10. A titre d'exemple non limitatif, le substrat 1 peut être réalisé en silicium, et la couche diélectrique 10 peut être réalisée en dioxyde de silicium SiO₂. Une telle couche diélectrique 10 est particulièrement adaptée à la formation du film superficiel 2 en MX₂, par exemple par un dépôt de couches atomiques ou par une épitaxie en phase vapeur aux organométalliques. Le dépôt de couches atomiques, pouvant être effectué à basse température (inférieure à 300°C), est avantageux par rapport à d'autres techniques telles qu'une épitaxie en phase vapeur aux organométalliques ou un dépôt chimique en phase vapeur.

Le film superficiel 2 comprend un ensemble de monocouches liées entre elles par des liaisons de van der Waals. A titre d'exemple non limitatif, le film superficiel 2 peut présenter une épaisseur de 2 nm. Le nombre de monocouches est avantageusement inférieur ou égal à 50.

L'étape a) est avantageusement exécutée de sorte que MX₂ est choisi pour posséder un désaccord de maille cristalline avec le nitrure d'aluminium AlN polycristallin inférieur ou égal à 1,5%. L'étape a) est avantageusement exécutée de sorte que MX₂ est choisi parmi le disulfure de molybdène MoS₂, le disulfure de tungstène WS₂, le disulfure de vanadium VS₂.

Le film superficiel 2 de MX₂ permet d'orienter la croissance cristalline du film 3 de nitrure d'aluminium AlN polycristallin lors de l'étape b), plus précisément dans la direction « c » (axe vertical) du système cristallin hexagonal.

### Etape b)

L'étape b) consiste à former un film 3 de nitrure d'aluminium AlN polycristallin, possédant des joints de grain, sur le film superficiel 2.

L'étape b) est avantageusement exécutée de sorte que le film 3 de nitrure d'aluminium AlN polycristallin présente une épaisseur inférieure ou égale à 5 nm. L'épaisseur est avantageusement comprise entre 3 nm et 4 nm.

L'étape b) est avantageusement exécutée par un dépôt physique en phase vapeur.

### Etape c)

L'étape c) consiste à diffuser des éléments E métalliques dans le film superficiel 2, à travers les joints de grain du film 3 de nitrure d'aluminium AlN polycristallin. La diffusion est de nature chimique en raison d'un gradient de concentration chimique.

Les éléments E métalliques sont choisis pour réagir chimiquement avec MX₂ par une réaction d'oxydoréduction de manière à transformer les liaisons de van der Waals en liaisons covalentes. Par exemple, lorsque le chalcogène «X» est le soufre S, les éléments E métalliques permettent de former des sulfures métalliques EₓS_{y} au dépend du MS₂ initial, « E » désignant le métal composant les éléments E métalliques. Les liaisons de van der Waals du MS₂ initial sont transformées en liaisons covalentes du métal de transition « M » et en liaisons covalentes du EₓS_{y}.

Les éléments E métalliques diffusés lors de l'étape c) sont avantageusement des atomes choisis comme agent réducteur du MX₂. Lorsque l'étape a) est exécutée de sorte que MX₂ est le disulfure de molybdène MoS₂, alors les atomes choisis comme agent réducteur du disulfure de molybdène MoS₂ sont avantageusement choisis parmi le gallium Ga, l'aluminium Al, le manganèse Mn. Par exemple, les atomes de gallium Ga permettent de réduire le disulfure de molybdène MoS₂ afin de former des sulfures de gallium GaₓS_{y} au dépend du disulfure de molybdène MoS₂ initial. Les liaisons de van der Waals du disulfure de molybdène MoS₂ initial sont transformées en liaisons covalentes du molybdène Mo et en liaisons covalentes du GaₓS_{y}, avec une libération d'un sulfure de gallium GaS sous forme gazeuse.

Selon un premier mode de mise en oeuvre, l'étape c) est précédée d'une exposition des éléments E métalliques sur le film 3 de nitrure d'aluminium AlN polycristallin. L'exposition des éléments E métalliques sur le film 3 de nitrure d'aluminium AlN polycristallin peut consister à déposer des atomes, choisis comme agent réducteur du MX₂, sur le film 3 de nitrure d'aluminium AlN polycristallin. A titre d'exemples non limitatifs, le dépôt des atomes sur le film 3 de nitrure d'aluminium AlN polycristallin peut être exécuté par une épitaxie en phase vapeur aux organométalliques ou par une épitaxie par jet moléculaire.

Selon un deuxième mode de mise en oeuvre, l'étape c) est précédée d'une formation d'un matériau 4, comportant les éléments E métalliques, sur le film 3 de nitrure d'aluminium AlN polycristallin. Le matériau 4 est un matériau solide. Le matériau 4 formé présente avantageusement une épaisseur strictement inférieure à 3 nm. Le matériau 4 peut être formé par une épitaxie en phase vapeur aux organométalliques ou par une épitaxie par jet moléculaire. Lorsque l'étape a) est exécutée de sorte que MX₂ est le disulfure de molybdène MoS₂ et que les atomes choisis comme agent réducteur du disulfure de molybdène MoS₂ sont des atomes de gallium Ga, le matériau 4 formé peut être une fine couche de nitrure de gallium GaN. A titre d'exemple non limitatif, la fine couche de nitrure de gallium GaN formant le matériau 4, d'une épaisseur strictement inférieure à 3 nm, peut être obtenue par une épitaxie en phase vapeur aux organométalliques avec les paramètres expérimentaux suivants :
- température comprise entre 800°C et 1040°C,
- atmosphère de type NH₃/N₂ ou NH₃/H₂,
- gaz précurseurs choisis parmi le triméthylgallium (TMGa) et le triéthylgallium (TEGa),
- pression comprise entre 150 mbar et 400 mbar.

La diffusion des éléments E métalliques à travers les joints de grain du film 3 de nitrure d'aluminium AlN polycristallin peut s'effectuer de manière concomitante à la formation du matériau 4, par exemple par épitaxie en phase vapeur aux organométalliques. Par exemple, des atomes (formant les éléments E métalliques) qui atteignent la surface du film 3 de nitrure d'aluminium AlN polycristallin sont disponibles pour diffuser à travers le film 3 de nitrure d'aluminium AlN polycristallin.

### Etape d)

L'étape d) consiste à former une couche cristalline C sur le film 3 de nitrure d'aluminium AlN polycristallin après l'étape c).

Lorsque l'étape c) est précédée d'une formation d'un matériau 4, comportant les éléments E métalliques, sur le film 3 de nitrure d'aluminium AlN polycristallin, alors l'étape d) est avantageusement précédée d'une suppression des résidus du matériau 4 formé sur le film 3 de nitrure d'aluminium AlN polycristallin, après la diffusion des éléments E métalliques dans le film superficiel 2 à l'issue de l'étape c). A titre d'exemple non limitatif, lorsque le matériau 4 est une fine couche de nitrure de gallium GaN, la suppression des résidus peut être exécutée par un nettoyage de surface avec du dihydrogène H₂ à une pression de 150 mbar.

L'étape d) est avantageusement exécutée de sorte que la couche cristalline C est réalisée dans un matériau cristallin possédant un désaccord de maille cristalline avec le nitrure d'aluminium AlN polycristallin inférieur ou égal à 1,5%. L'étape d) est avantageusement exécutée de sorte que la couche cristalline C est réalisée dans un matériau cristallin choisi parmi le carbure de silicium SiC et un alliage de type III-N. L'alliage de type III-N est avantageusement choisi parmi le nitrure d'aluminium AlN, le nitrure de gallium GaN, le nitrure d'aluminium-gallium AlGaN.

L'étape d) est avantageusement exécutée par un dépôt physique en phase vapeur ou par une épitaxie en phase vapeur aux organométalliques. En particulier, l'épitaxie en phase vapeur aux organométalliques est possible, malgré une haute température pouvant dépasser par exemple 950°C, grâce à la présence du film 3 de nitrure d'aluminium AlN polycristallin qui permet une reprise d'épitaxie. En l'absence du film 3 de nitrure d'aluminium AlN polycristallin, le film superficiel 2 de MX₂ subirait une décomposition thermique.

L'étape d) est avantageusement exécutée de sorte que la couche cristalline C présente une épaisseur supérieure ou égale à 200 nm. A titre d'exemple non limitatif, l'épaisseur de la couche cristalline C peut être de l'ordre du micron.

Un objet de l'invention est un empilement, comportant :
- un substrat 1 comprenant un film superficiel 2 réalisé dans un dichalcogénure d'un métal de transition, noté MX₂, où « M » désigne un métal de transition et « X » désigne un chalcogène ; le film superficiel 2 comprenant des éléments E métalliques adaptés pour réagir chimiquement avec MX₂ par une réaction d'oxydoréduction, le film superficiel 2 comprenant un ensemble de monocouches liées entre elles par des liaisons covalentes ;
- un film 3 de nitrure d'aluminium AlN polycristallin, possédant des joints de grain, et s'étendant sur le film superficiel 2.

Le substrat 1 peut être revêtu d'une couche diélectrique 10. A titre d'exemple non limitatif, le substrat 1 peut être réalisé en silicium, et la couche diélectrique 10 peut être réalisée en dioxyde de silicium SiO₂.

Le métal de transition « M » peut être choisi parmi le titane Ti, le zirconium Zr, le hafnium Hf, le vanadium V, le niobium Nb, le tantale Ta, le chrome Cr, le molybdène Mo, le tungstène W, le rhénium Re. Le chalcogène « X » peut être choisi parmi le soufre S, le sélénium Se, le tellure Te. MX₂ est avantageusement choisi pour posséder un désaccord de maille cristalline avec le nitrure d'aluminium AlN polycristallin inférieur ou égal à 1,5%. MX₂ est avantageusement choisi parmi le disulfure de molybdène MoS₂, le disulfure de tungstène WS₂, le disulfure de vanadium VS₂.

Par exemple, lorsque le chalcogène « X » est le soufre S, les éléments E métalliques forment des sulfures métalliques EₓS_{y} au dépend du MS₂ initial, « E » désignant le métal composant les éléments E métalliques. Les éléments E métalliques sont avantageusement des atomes choisis comme agent réducteur du MX₂. Lorsque MX₂ est le disulfure de molybdène MoS₂, alors les atomes choisis comme agent réducteur du disulfure de molybdène MoS₂ sont avantageusement choisis parmi le gallium Ga, l'aluminium Al, le manganèse Mn. Par exemple, les atomes de gallium Ga permettent de réduire le disulfure de molybdène MoS₂ afin de former des sulfures de gallium GaₓS_{y} au dépend du disulfure de molybdène MoS₂ initial.

A titre d'exemple non limitatif, le film superficiel 2 peut présenter une épaisseur de 2 nm. Le nombre de monocouches est avantageusement inférieur ou égal à 50.

Le film 3 de nitrure d'aluminium AlN polycristallin présente avantageusement une épaisseur inférieure ou égale à 5 nm. L'épaisseur est avantageusement comprise entre 3 nm et 4 nm. Le film 3 de nitrure d'aluminium AlN polycristallin peut comporter les éléments E métalliques en proportion résiduelle.

Un objet de l'invention est un dispositif, comportant :
- un empilement selon l'invention ;
- une couche cristalline C, s'étendant sur le film 3 de nitrure d'aluminium AlN polycristallin.

La couche cristalline C est avantageusement réalisée dans un matériau cristallin possédant un désaccord de maille cristalline avec le nitrure d'aluminium AlN polycristallin inférieur ou égal à 1,5%. La couche cristalline C est avantageusement réalisée dans un matériau cristallin choisi parmi le carbure de silicium SiC et un alliage de type III-N. L'alliage de type III-N est avantageusement choisi parmi le nitrure d'aluminium AlN, le nitrure de gallium GaN, le nitrure d'aluminium-gallium AlGaN.

La couche cristalline C présente avantageusement une épaisseur supérieure ou égale à 200 nm. A titre d'exemple non limitatif, l'épaisseur de la couche cristalline C peut être de l'ordre du micron.

A titre d'exemples non limitatifs, le dispositif peut être un dispositif électronique de puissance, ou un filtre acoustique pour des signaux RF (radio-fréquence).

L'invention ne se limite pas aux modes de réalisation exposés. L'homme du métier est mis à même de considérer leurs combinaisons techniquement opérantes, et de leur substituer des équivalents.

## Revendications

1. Procédé de fabrication d'une couche cristalline (C), comportant les étapes :
a) utiliser un substrat (1) comprenant un film superficiel (2) réalisé dans un dichalcogénure d'un métal de transition, noté MX₂, où « M » désigne un métal de transition et « X » désigne un chalcogène ; le film superficiel (2) comprenant un ensemble de monocouches liées entre elles par des liaisons de van der Waals ;
b) former un film (3) de nitrure d'aluminium AlN polycristallin, possédant des joints de grain, sur le film superficiel (2) ;
c) diffuser des éléments (E) métalliques dans le film superficiel (2), à travers les joints de grain du film (3) de nitrure d'aluminium AlN polycristallin, les éléments (E) métalliques étant choisis pour réagir chimiquement avec MX₂ par une réaction d'oxydoréduction de manière à transformer les liaisons de van der Waals en liaisons covalentes ;
d) former une couche cristalline (C) sur le film (3) de nitrure d'aluminium AlN polycristallin après l'étape c).

2. Procédé selon la revendication 1, dans lequel l'étape c) est précédée d'une exposition des éléments (E) métalliques sur le film (3) de nitrure d'aluminium AlN polycristallin.

3. Procédé selon la revendication 1, dans lequel l'étape c) est précédée d'une formation d'un matériau (4), comportant les éléments (E) métalliques, sur le film (3) de nitrure d'aluminium AlN polycristallin.

4. Procédé selon la revendication 3, dans lequel l'étape d) est précédée d'une suppression des résidus du matériau (4) formé sur le film (3) de nitrure d'aluminium AlN polycristallin, après la diffusion des éléments (E) métalliques dans le film superficiel (2) à l'issue de l'étape c).

5. Procédé selon l'une des revendications 1 à 4, dans lequel les éléments (E) métalliques diffusés lors de l'étape c) sont des atomes choisis comme agent réducteur du MX₂.

6. Procédé selon l'une des revendications 1 à 5, dans lequel l'étape a) est exécutée de sorte que MX₂ est choisi pour posséder un désaccord de maille cristalline avec le nitrure d'aluminium AlN polycristallin inférieur ou égal à 1,5%.

7. Procédé selon la revendication 6, dans lequel l'étape a) est exécutée de sorte que MX₂ est choisi parmi le disulfure de molybdène MoS₂, le disulfure de tungstène WS₂, le disulfure de vanadium VS₂.

8. Procédé selon la revendication 7 en combinaison avec la revendication 5, dans lequel :
- l'étape a) est exécutée de sorte que MX₂ est le disulfure de molybdène MoS₂;
- les atomes choisis comme agent réducteur du disulfure de molybdène MoS₂ sont choisis parmi le gallium Ga, l'aluminium Al, le manganèse Mn.

9. Procédé selon l'une des revendications 1 à 8, dans lequel l'étape d) est exécutée de sorte que la couche cristalline (C) est réalisée dans un matériau cristallin possédant un désaccord de maille cristalline avec le nitrure d'aluminium AlN polycristallin inférieur ou égal à 1,5%.

10. Procédé selon l'une des revendications 1 à 9, dans lequel l'étape d) est exécutée de sorte que la couche cristalline (C) est réalisée dans un matériau cristallin choisi parmi le carbure de silicium SiC et un alliage de type III-N.

11. Procédé selon la revendication 10 en combinaison avec la revendication 9, dans lequel l'alliage de type III-N est choisi parmi le nitrure d'aluminium AlN, le nitrure de gallium GaN, le nitrure d'aluminium-gallium AlGaN.

12. Procédé selon l'une des revendications 1 à 11, dans lequel l'étape b) est exécutée de sorte que le film (3) de nitrure d'aluminium AlN polycristallin présente une épaisseur inférieure ou égale à 5 nm.

13. Procédé selon l'une des revendications 1 à 12, dans lequel l'étape d) est exécutée de sorte que la couche cristalline (C) présente une épaisseur supérieure ou égale à 200 nm.

14. Empilement, comportant :
- un substrat (1) comprenant un film superficiel (2) réalisé dans un dichalcogénure d'un métal de transition, noté MX₂, où « M » désigne un métal de transition et « X » désigne un chalcogène ; le film superficiel (2) comprenant des éléments (E) métalliques adaptés pour réagir chimiquement avec MX₂ par une réaction d'oxydoréduction, le film superficiel (2) comprenant un ensemble de monocouches liées entre elles par des liaisons covalentes ;
- un film (3) de nitrure d'aluminium AlN polycristallin, possédant des joints de grain, et s'étendant sur le film superficiel (2).

15. Dispositif, comportant :
- un empilement selon la revendication 14 ;
- une couche cristalline (C), s'étendant sur le film (3) de nitrure d'aluminium AlN polycristallin.
